Europäisches Patentamt

European Patent Office

Office européen des brevets

(19)

(11) Veröffentlichungsnummer: **0 283 908 B1**

(12) **EUROPÄISCHE PATENTSCHRIFT**

(45) Veröffentlichungstag der Patentschrift: **29.05.91**

(51) Int. Cl.⁵: **G11C 8/00, G11C 29/00**

(21) Anmeldenummer: **88104117.2**

(22) Anmeldetag: **15.03.88**

(54) **Mehrstufige integrierte Dekodereinrichtung.**

(30) Priorität: **16.03.87 DE 3708522**
**16.03.87 DE 3708532**

(43) Veröffentlichungstag der Anmeldung:
**28.09.88 Patentblatt 88/39**

(45) Bekanntmachung des Hinweises auf die
Patenterteilung:
**29.05.91 Patentblatt 91/22**

(84) Benannte Vertragsstaaten:
**AT DE FR GB IT NL**

(56) Entgegenhaltungen:
**EP-A- 0 078 502**
**DE-A- 2 538 373**

**INTEGRATION, THE VLSI JOURNAL, Band 2,
Nr. 4, Dezember 1984, Seiten 309-330, Elsevier Science Publishers B.V., Amsterdam,
NL; K.K. SALUJA et al.: "Testable design of
large random access memories"**

(73) Patentinhaber: **Siemens Aktiengesellschaft**
**Wittelsbacherplatz 2**
**W-8000 München 2(DE)**

(72) Erfinder: **Hoffmann, Kurt, Dr. Prof.**
**Nelkenweg 20**
**W-8028 Taufkirchen(DE)**
Erfinder: **Kowarik, Oskar, Dr. rer. nat.**
**Goethering 70**
**W-8018 Grafing(DE)**
Erfinder: **Kraus, Rainer, Dipl.-Phys.**
**Weidener Strasse 21**
**W-8000 München 83(DE)**

## Beschreibung

Die vorliegende Erfindung betrifft eine mehrstufige integrierte Dekodereinrichtung nach dem Oberbegriff des Patentanspruches 1.

Eine gattungsgemäße Einrichtung ist aus folgenden Veröffentlichungen bekannt:
a) IEEE JOURNAL OF SOLID-STATE CIRCUITS, VOL. SC-18, NO.5, OCT. 1983, Seiten 457 bis 462, "A 70 ns High Density 64K CMOS Dynamic RAM" und
b) 1986 IEEE International Solid-State Circuits Conference, Seiten 260 bis 261 und 365; "A 47 ns 64KW x 4b CMOS DRAM with Relaxed Timing Requirements".

In beiden Veröffentlichungen sind im Zusammenhang mit integrierten Halbleiterspeichern gattungsgemäße Einrichtungen geoffenbart. Sie lassen sich sowohl (ebenso wie die vorliegende Erfindung) als Wort- wie auch als Bitleitungsdekoder einsetzen. Sie enthalten (zumindest andeutungsweise) im wesentlichen drei Gruppen von Teilschaltungen: Vordekoder, Hauptdekoder und Nachdekoder. Die vorliegende Erfindung geht von den Teilen aus, die Vor- und Hauptdekoder betreffen. Sie läßt sich selbstverständlich, was jedem Fachmann einleuchtet, mit Nachdekodern im Sinne der obengenannten Veröffentlichungen kombinieren.

Aufgabe der vorliegenden Erfindung ist es, gattungsgemäße Dekodereinrichtungen mit möglichst einfachen Mitteln so zu erweitern, daß sie es ermöglichen, je nach Anwendungsfall mehr als eine Wortleitung bzw. Bitleitung beispielsweise eines Blockes von Speicherzellen eines Halbleiterspeichers gleichzeitig, d.h. parallel zueinander anzusprechen.

Diese Aufgabe wird gelöst bei einer gattungsgemäßen Dekodereinrichtung durch die kennzeichnenden Merkmale des Patentanspruches 1. Vorteilhafte Aus- und Weiterbildungen sind in Unteransprüchen gekennzeichnet.

In diesem Zusammenhang wird ausdrücklich darauf hingewiesen, daß die vorliegende Erfindung auch mit der vorteilhaften Dekodereinrichtung nach dem prioritätsgleich angemeldeten Schutzrecht EP-A-0 282 975 kombinierbar ist. Besonders gut anwenden lassen sich diese Erfindungen in Verbindung mit den ebenfalls prioritätsgleichen Schutzrechten EP-A-0 282 976, EP-A-0 286 852, EP-A-0 283 906 und EP-A-0 283 907.

Die Erfindung wird nun anhand der Figuren näher erläutert. Es zeigen:
Fig. 1 eine Dekodereinrichtung nach dem Stand der Technik.
Die Fig. 2 bis 7 vorteilhafte Ausgestaltungen der vorliegenden Erfindung.

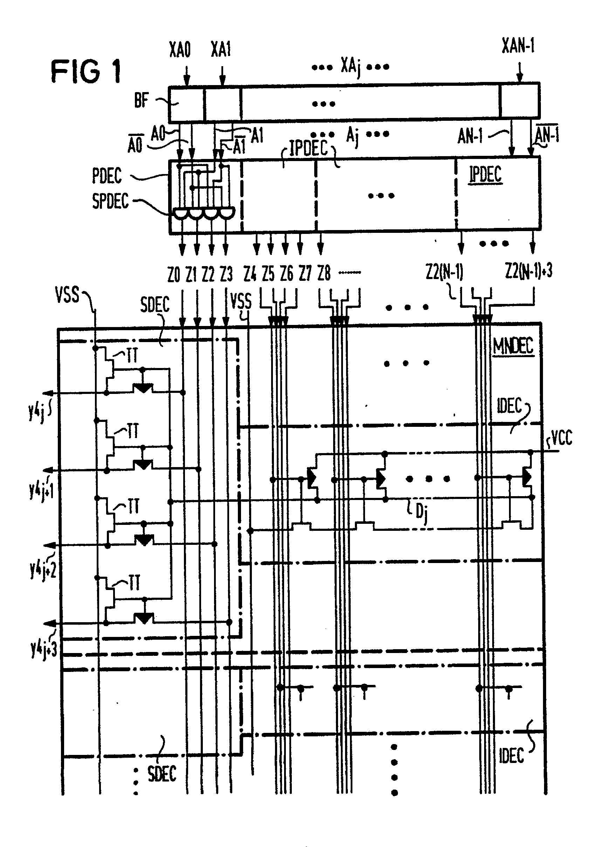

Zur Funktionsweise einer Dekodereinrichtung nach dem Stande der Technik, wie sie beispielsweise in Fig. 1 dargestellt ist, wird im folgenden nur kurz eingegangen. Einem Fachmann auf dem betreffenden Fachgebiet ist dies wohl bekannt.

In einer Bufferschaltung BF werden Adreß-Eingangssignale XAO bis beispielsweise XAN-1 (N ist geradzahlig) zwischengespeichert und gegebenenfalls (wie hier angenommen) als wahre Adressen AO bis AN-1 und dazu komplementäre Adressen $\overline{AO}$ bis $\overline{AN-1}$ weitergegeben an den Vordekoder PDEC. Der Vordekoder PDEC ist PPn geteilt in einen Selektionsvordekoder SPDEC und in beispielsweise (N/2)-1 innere Vordekoder IPDEC. Es könnten auch (bei geeignetem Wert für N) (N/3)-1 oder ähnlich viele innere Vordekoder IPDEC sein. Beim Stand der Technik nach Fig. 1 sind der Selektionsvordekoder SPDEC und die inneren Vordekoder IPDEC alle gleich. Es handelt sich dabei jeweils um einen sog. 1-aus-n-Dekoder (im konkreten Beispiel ist n gleich zwei voneinander unabhängigen Adressen Aj).

Dem Vordekoder PDEC nachgeschaltet ist ein Hauptdekoder MNDEC. Er weist eine Anzahl von Selektionsdekodern SDEC und von inneren Dekodern IDEC auf. Je ein Selektionsdekoder SDEC und ein innerer Dekoder IDEC sind einander funktionell und elektrisch zugeordnet und umgekehrt. Während die inneren Dekoder IDEC von den Ausgangssignalen Z4... der inneren Vordekoder IPDEC angesteuert werden, werden die Selektionsdekoder SDEC von den Ausgangssignalen Z0 bis Z3 des Selektionsvordekoders SPDEC angesteuert. Im Falle des Einsatzes als Bitleitungsdekoder steuert jedes Ausgangssignal Y4j ... eines Selektionsdekoders SDEC über ein nicht dargestelltes Transfertransistorpärchen genau eine Bitleitung beispielsweise eines Blockes von Speicherzellen des Halbleiterspeichers an.

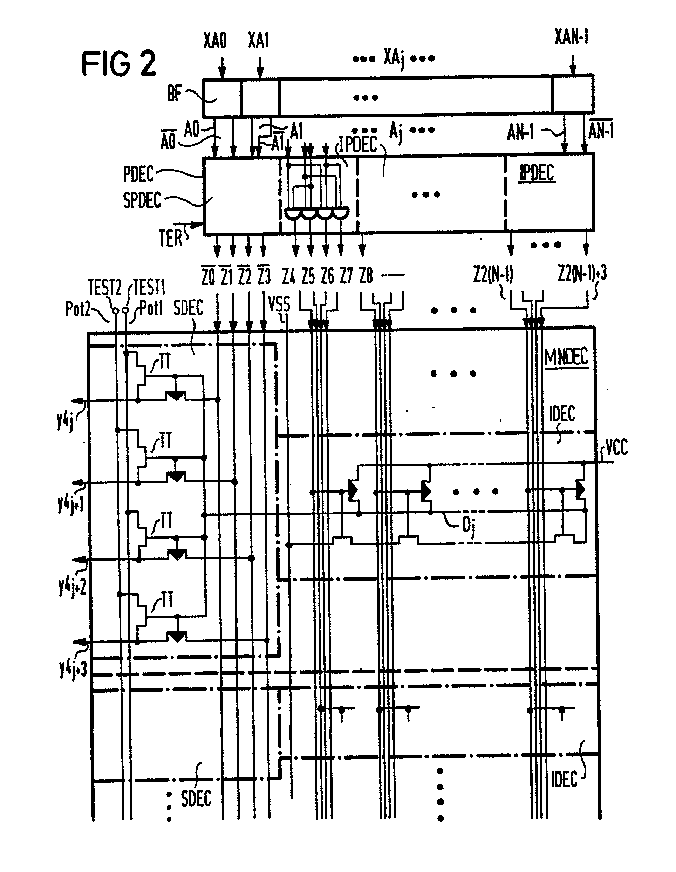

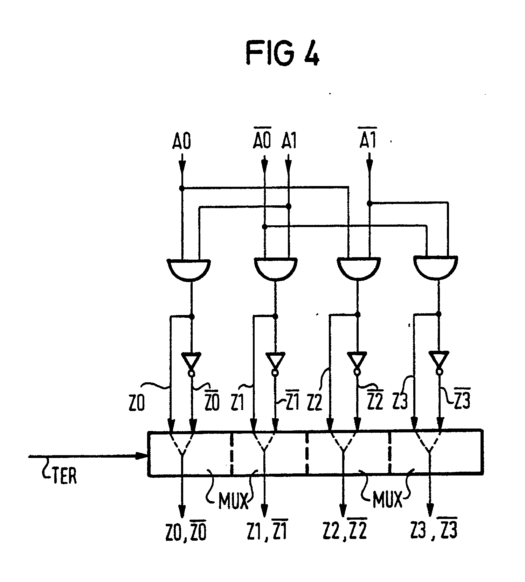

Die erfindungsgemäße Dekodereinrichtung nach den Fig. 2 bis 7 unterscheidet sich von der nach dem Stande der Technik (siehe Fig. 1) in folgenden zwei Punkten:
a) Jedem Ausgang des Selektionsvordekoders SPDEC sind ein Multiplexer MUX und ein Inverter I vorgeschaltet. In Abhängigkeit von einem Test-Enable-Redundanz-Signal TER liegen als Ausgangssignale Z0, $\overline{Z0}$; Z1,$\overline{Z1}$; Z2,$\overline{Z2}$; Z3,$\overline{Z3}$ des Selektionsvordekoders SPDEC entweder die Ausgangssignale $\overline{Z0},\overline{Z1},\overline{Z2},\overline{Z3}$ des Inverters I oder die nicht invertierten Signale Z0,Z1,Z2,Z3 an. Die Darstellung des Selektionsvordekoders SPDEC erfolgt in den Fig. 2,3,5,7 der Übersichtlichkeit halber nur in Form eines Blockschaltbildes; in Fig. 4 ist der Selektionsvordekoder SPDEC genauer dargestellt.
b) Beim Stande der Technik (siehe Fig. 1) sind die Ausgänge jedes Selektionsdekoders SDEC über die Sourceanschlüsse von Transfertransistoren TT schaltbar mit dem Bezugspotential VSS verbunden. Erfindungsgemäß sind die Sources einer ersten Hälfte der Transfertransistoren TT jedoch mit einer ersten Potentialleitung Pot1 verbunden und eine zweite Hälfte der Transfertransistoren TT mit einer zweiten Potentialleitung Pot2. Beide Potentialleitungen Pot1,Pot2 weisen unabhängig voneinander je nach Ansteuerung einen von zwei zueinander komplementären Pegeln auf. Beispielsweise weisen beide im Normalbetrieb das Bezugspotential VSS auf, was die übliche Ansteuerung von Bitleitungen eines Halbleiterspeichers ermöglicht. Im Testbetrieb, bei dem beispielsweise nur jede zweite Bitleitung gleichzeitig aktiviert sein soll (paralleles Einschreiben bzw. Auslesen für Prüfmuster Checkerboard; es könnten auch die Wortleitungen angeschlossen sein), liegen an der ersten Potentialleitung Pot1 als logischer Pegel des Versorgungspotential VCC des Halbleiterspeichers an und an der zweiten Potentialleitung Pot2 als logischer Pegel das Bezugspotential VSS an. Entsprechende Pegel weisen im Testfall auch die Ausgänge der Selektionsdekoder SDEC auf.

Es ist vorteilhaft (siehe Fig. 2), daß an den beiden Potentialleitungen Pot1, Pot2 Testsignale TEST1, TEST2 anliegen, deren logische Pegel unabhängig voneinander einstellbar sind, beispielsweise auf die Werte Versorgungspotential VCC und Bezugspotential VSS.

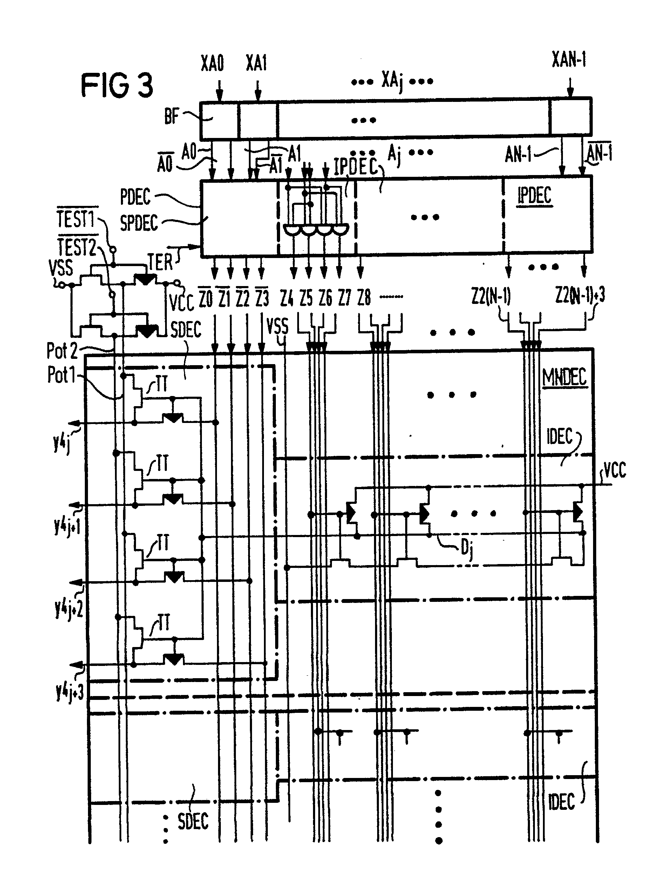

In einer weiteren Ausführungsform (siehe Fig. 3) ist es weiterhin vorteilhaft, daß die Testsignale TEST1, TEST2 Ausgangssignale von CMOS-Invertern sind, die eingangsmäßig jeweils mit einem ersten bzw. einem zweiten Test-Hilfssignal $\overline{TEST1}$, $\overline{TEST2}$ beschaltet sind und die sourcemäßig zwischen Versorgungspotential VCC und Bezugspotential VSS geschaltet sind.

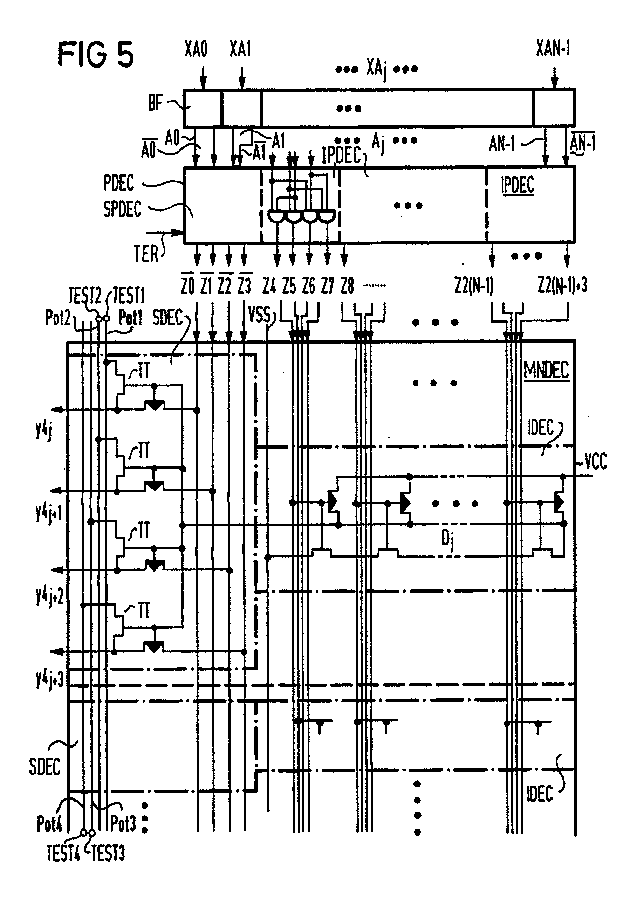

In vorteilhafter Weiterbildung der Erfindung (vgl. FIG 5) ist je Selektionsdekoder SDEC, allgemein ausgedrückt, wenigstens eine Gruppe von Ausgängen Y4j ... bis maximal jeder der Ausgänge Y4j ... über den Sourceanschluß des dem jeweiligen Ausgang zugehörigen Transfertransistors TT mit einer eigenen Potentialleitung Pot1 ... Pot4 verbunden. Alle Potentialleitungen Pot1 bis Pot4 weisen unabhängig voneinander je nach Ansteuerung jeweils einen von zwei zueinander komplementären logischen Pegel auf.

Dies hat den Vorteil, daß außer dem Prüfmuster Checkerboard ('1010') auch kompliziertere checkerboard-ähnliche Prüfmuster (z.B. '11001100') testbar sind; ebenso ganz einfache Prüfmuster wie "All 1's".

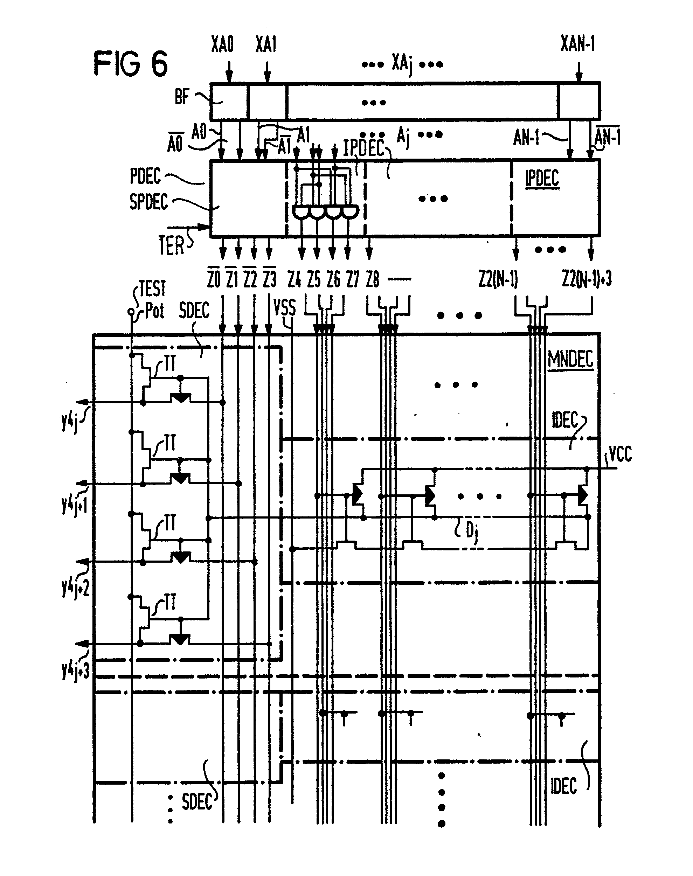

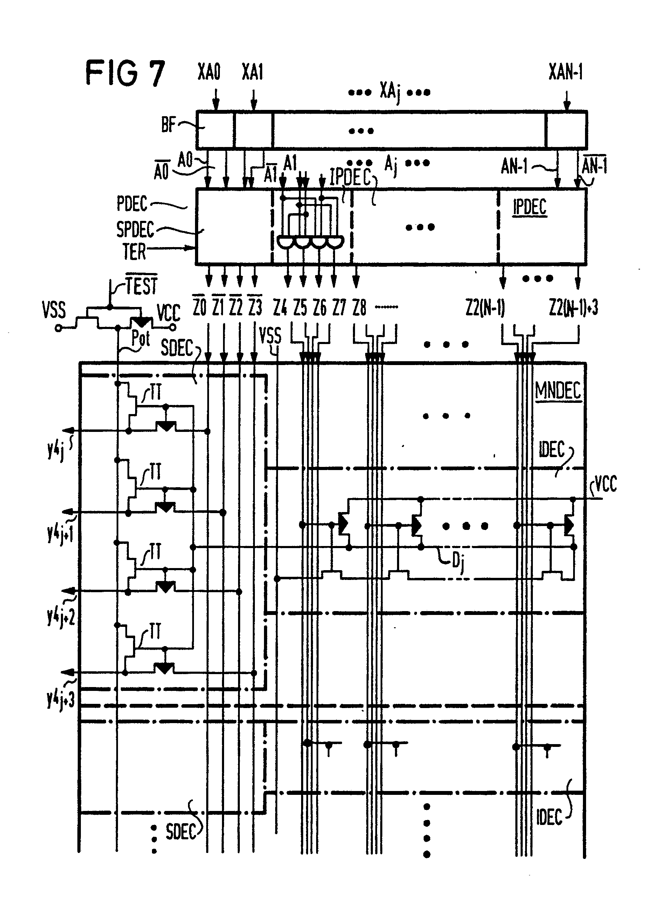

Die FIG. 6 und 7 zeigen vereinfachte, vorteilhafte Ausführungsformen. Die Ausführungsform nach FIG 6 enthält anstelle der wenigstens zwei Potentialleitungen Pot1,Pot2 nur eine einzige Potentialleitung Pot. An der einen Potentialleitung Pot sind jeder Ausgang Y4j,Y4j + 1, ... jedes Selektionsdekoders SDEC über den Sourceanschluß eines Transfertransistors TT angeschlossen.

Die Ausführungsform nach FIG 7 kombiniert die Ausführungsformen nach den FIG 3 und 6. Ihre Funktionsweise ist für den Fachmann in Verbindung mit den obenstehenden Ausführungen selbsterklärend.

Die Ausführungsformen nach den FIG 6 und 7 schränken zwar die obengenannte Anzahl der verwendbaren Prüfmuster ein. Sie bieten dafür jedoch den Vorteil des einfacheren und platzsparenderen (Wegfall wenigstens einer üblicherweise viel Raum einnehmenden Potentialleitung) Aufbaus.

Ein wichtiger Vorteil der vorliegenden Erfindung besteht bei Verwendung als Bitleitungsdekoder in der Möglichkeit, auch Redundanzspeicherzellen testen zu können, ohne daß der sonst übliche Redundanzmechanismus (z.B. über Laser-Links) aktiviert zu sein braucht (was meist irreversibel ist) und gleichzeitig eine Bitleitung (mit angenommenermaßen mindestens einer defekten Speicherzelle) des Normalspeicherzellenfeldes ausblenden zu können: Durch einfaches Anlegen der Adresse der defekten Speicherzelle an die gesamte Dekodereinrichtung, gleichzeitiges Anlegen des Test-Enable-Redundanz-Signals TER und Setzen von mindestens einer der Potentialleitungen Pot1,Pot2,Pot3,Pot4 auf Versorgungspotential VCC werden mehrere bis alle Dekoderausgänge Y4j... (auch diejenigen für Redundanzbitleitungen!) des gesamten Dekoders aktiviert mit Ausnahme desjenigen Dekoderausganges, der mit der der defekten Speicherzelle zugeordneten Bitleitung verbunden ist.

**Ansprüche**

1. Mehrstufige integrierte Dekodereinrichtung, enthaltend wenigstens

   - eine Vordekodereinrichtung mit Selektionsvordekoder und internen Vordekodereinheiten,
     - der Selektionsvordekoder und jede interne Vordekodereinheit sind als 1-Aus-n-Dekoder ausgelegt
   - und eine Hauptdekodereinrichtung mit mehreren Selektionsdekodern und inneren Dekodern, **gekennzeichnet durch** folgende Merkmale:
   - Jedem Ausgang des Selektionsvordekoders (SPDEC) sind ein Multiplexer (MUX) und ein Inverter (I) vorgeschaltet,
   - in Abhängigkeit von einem Test-Enable-Redundanz-Signal (TER) liegen als Aus-

gangssignale (Z0,$\overline{Z0}$; Z1,$\overline{Z1}$; Z2,$\overline{Z2}$; Z3,$\overline{Z3}$) des Selektionsvordekoders (SPDEC) entweder die Ausgangssignale ($\overline{Z0},\overline{Z1},\overline{Z2},\overline{Z3}$) des Inverters (I) oder die nicht invertierten Signale (Z0,Z1,Z2,Z3) an,

- eine erste Hälfte (Y4j,Y4j+2) der Ausgänge jedes Selektionsdekoders (SDEC) ist über den Sourceanschluß eines Transfertransistors (TT) mit einer ersten Potentialleitung (Pot1) verbunden und eine zweite Hälfte (Y4j+1,Y4j+3) der Ausgänge jedes Selektionsdekoders (SDEC) ist über den Sourceanschluß eines Transfertransistors (TT) mit einer zweiten Potentialleitung (Pot2) verbunden,
- beide Potentialleitungen (Pot1, Pot2) weisen unabhängig voneinander einen von zwei zueinander komplementären Pegeln auf.

2. Mehrstufige integrierte Dekodereinrichtung nach Anspruch 1, **dadurch gekennzeichnet,** daß an jeder Potentialleitung (Pot1,Pot2) ein Testsignal (TEST1, TEST2) anliegt, dessen logische Pegel einstellbar sind.

3. Mehrstufige integrierte Dekodereinrichtung nach Anspruch 2, **dadurch gekennzeichnet,** daß die Testsignale (TEST1,TEST2) Ausgangssignale jeweils eines CMOS-Inverters sind, der eingangsmäßig jeweils mit einem Test-Hilfssignal ($\overline{\text{TEST1}},\overline{\text{TEST2}}$) beschaltet ist und der sourcemäßig zwischen Versorgungspotential (VCC) und Bezugspotential (VSS) geschaltet ist.

4. Mehrstufige integrierte Dekodereinrichtung nach einem der Ansprüche 1 bis 3, **dadurch gekennzeichnet,** daß anstatt mit zwei Potentialeitungen wenigstens eine Gruppe von Ausgängen bis maximal jeder der Ausgänge (Y4j, ...) jedes Selektionsdekoders (SDEC) über den Sourceanschluß des jeweils zugehörigen Transfertransistors (TT) mit einer eigenen Potentialleitung (Pot1,Pot2,Pot3,Pot4) verbunden ist und daß diese Potentialleitungen (Pot1,Pot2,Pot3,Pot4) unabhängig voneinander jeweils einen von zwei zueinander komplementäre logische Pegel aufweisen.

5. Mehrstufige integrierte Dekodereinrichtung nach einem der Ansprüche 1 bis 3, **dadurch gekennzeichnet,** daß sie anstelle der zwei Potentialleitungen (Pot1,Pot2) lediglich eine einzige Potentialleitung (Pot) aufweist, die wahlweise einen von zwei zueinander komplementären logischen Pegeln aufweist, und daß jeder Ausgang (Y4j,Y4j+1, ...) jedes Selektionsdekoders (SDEC) über den Sourceanschluß eines Transfertransistors (TT) mit dieser Potentialleitung (Pot) verbunden ist.

## Claims

1. Integrated multistage decoder device comprising at least
   - a preliminary decoder device having a selection preliminary decoder and internal preliminary decoder units,
     - selection preliminary decoder and each internal preliminary decoder unit being designed as 1-from-n decoders
   - and a main decoder device having a plurality of selection decoders and internal decoders, characterised by the following features:
   - a multiplexer (MUX) and an inverter (I) are connected upstream of each output of the selection preliminary decoder (SPDEC),
   - depending upon a test-enable-redundancy signal (TER), either the output signals ($\overline{Z0}$, $\overline{Z1}$, $\overline{Z2},\overline{Z3}$) of inverter (I) or the non-inverted signals (Z0,Z1, Z2,Z3) are applied as output signals (Z0, $\overline{Z0}$; Z1, $\overline{Z1}$; Z2, $\overline{Z2}$; Z3, $\overline{Z3}$) of the selection preliminary decoder (SPDEC),
   - a first half (Y4j,Y4j+2) of the outputs of each selection decoder (SDEC) is connected to a first potential line (Pot1) through the source terminal of a transfer transistor (TT) and a second half (Y4j+1,Y4J+3) of the outputs of each selection decoder (SDEC) is connected to a second potential line (Pot2) through the source terminal of a transfer transistor (TT),
   - independently of one another, the two potential lines (Pot1, Pot2) have one of two mutually complimentary levels.

2. Integrated multistage decoder device according to Claim 1, characterised in that a test signal (TEST1, TEST2) whose logic levels are adjustable is applied to each potential line.

3. Integrated multistage decoder device according to Claim 2, characterised in that the test signals (TEST1, TEST2) are in each case the output signals of a CMOS inverter, to which a test auxiliary signal ($\overline{\text{TEST1}}$, $\overline{\text{TEST2}}$) is connected on the input side in each case and is connected through its source between a supply potential (VCC) and a reference potential (VSS).

4. Integrated multistage decoder device according to one of Claims 1 to 3, characterised in that instead of being connected to two potential lines at least one group of outputs up to at most each of the outputs (Y4j, ...) of each selection decoder (SDEC) is connected through the source terminal of the respective associated transfer transistor (TT) to its own potential line (Pot1,Pot2,Pot3,Pot4), and in that said potential lines (Pot1,Pot2,Pot3,Pot4) each have independently of one another one of two mutually complimentary logic levels.

5. Integrated multistage decoder device according to one of Claims 1 to 3, characterised in that instead of the two potential lines (Pot1,Pot2) it has only a single potential line (Pot), which optionally has one of two mutually complimentary logic levels, and in that each output (Y4j,Y4j + 1, ...) of each selection decoder (SDEC) is connected to said potential line (Pot) through the source terminal of a transfer transistor (TT).

## Revendications

1. Dispositif de décodage intégré à plusieurs étages, comportant au moins
   - un dispositif de prédécodage comportant un prédécodeur de sélection et une unité interne de prédécodage,
     - le prédécodeur de sélection et chaque unité interne de prédécodage étant réalisés sous la forme de décodeurs 1-parmi-n, et
   - un dispositif de décodage principal comportant plusieurs décodeurs de sélection et plusieurs décodeurs internes, remarquable par les caractéristiques suivantes:
     - en amont de chaque sortie du prédécodeur de sélection (SPDEC) sont branchés un multiplexeur (MUX) et un inverseur (I),
     - comme signaux de sortie (Z0,$\overline{Z0}$; Z1,$\overline{Z1}$; Z2,$\overline{Z2}$, Z3,$\overline{Z3}$) du prédécodeur de sélection (SPDEC) sont présents, en fonction d'un signal de redondance de validation de test (TER), soit les signaux de sortie ($\overline{Z0},\overline{Z1},\overline{Z2},\overline{Z3}$) de l'inverseur (I), soit les signaux non inversés (Z0,Z1,Z2,Z3),
     - une première moitié (Y4j,Y4j + 2) des sorties de chaque décodeur de sélection (SDEC) est raccordée à une première ligne de potentiel (Pot1), et une seconde moitié (Y4j + 1, Y4j + 3) des sorties de chaque décodeur de sélection (SDEC) est raccordée par l'intermédiaire de la borne de source d'un transistor de transfert (TT) à une seconde ligne de potentiel (Pot2),
   - les deux lignes de potentiel (Pot1, Pot2) possèdent, indépendamment l'une de l'autre, l'un de deux niveaux réciproquement complémentaires.

2. Dispositif de décodage intégré à plusieurs étages suivant la revendication 1, caractérisé par le fait que dans chaque ligne de potentiel (Pot1, Pot2) est présent un signal de test (TEST1, TEST2), dont les niveaux logiques sont réglables.

3. Dispositif de décodage intégré à plusieurs étages suivant la revendication 2, caractérisé par le fait que les signaux de test (TEST1, TEST2) sont les signaux de sortie d'un inverseur CMOS respectif, dont le côté entrée reçoit respectivement un signal auxiliaire de test ($\overline{TEST1}$, $\overline{TEST2}$) et dont le côté source est branché entre le potentiel d'alimentation (VCC) et le potentiel de référence (VSS).

4. Dispositif de décodage intégré à plusieurs étages suivant l'une des revendications 1 à 3, caractérisé par le fait qu'au moins un groupe de sorties et au maximum chacune des sorties (Y4j, ...) de chaque décodeur de sélection (SDEC) est raccordée, par la borne de source du transistor de transfert (TT) respectivement associé, à une ligne particulière de potentiel (Pot1, Pot2, Pot3, Pot4), au lieu d'être raccordée à deux lignes de potentiel, et que ces lignes de potentiel (Pot1, Pot2, Pot3, Pot4) possèdent, indépendamment les unes des autres, respectivement l'un de deux niveaux logiques réciproquement complémentaires.

5. Dispositif de décodage intégré à plusieurs étages suivant l'une des revendications 1 à 3, caractérisé par le fait qu'il comporte, à la place des deux lignes de potentiel (Pot1, Pot2), une seule ligne de potentiel, qui possède au choix l'un de deux niveaux logiques réciproquement complémentaires, et que chaque sortie (Y4j, Y4j + 1, ...) de chaque décodeur de sélection (SDEC) est raccordée, au moyen de la borne de source d'un transistor de transfert (TT), à cette ligne de potentiel (Pot).

# FIG 1

FIG 2

FIG 3

# FIG 4

EP 0 283 908 B1

FIG 5

10

FIG 6

FIG 7